# EUROPÄISCHE PATENTSCHRIFT

(11) **EP 1 866 466 B1**
(45) Veröffentlichungstag und Bekanntmachung des Hinweises auf die Patenterteilung: **07.07.2010**
(21) Anmeldenummer: 06724135.6
(22) Anmeldetag: 04.04.2006
(51) Int. Cl.: C30B 29/06, C30B 13/30

(54) **VERFAHREN ZUR HERSTELLUNG EINER EINKRISTALLINEN SI-SCHEIBE MIT ANNÄHERND POLYGONALEM QUERSCHNITT**
METHOD FOR PRODUCING A MONOCRYSTALLINE SI WAFER HAVING AN APPROXIMATELY POLYGONAL CROSS-SECTION
PROCEDE POUR PRODUIRE UNE TRANCHE DE SILICIUM MONOCRISTALLINE A SECTION PRATIQUEMENT POLYGONALE

(30) Priorität: 06.04.2005 DE 102005016776
(43) Veröffentlichungstag der Anmeldung: 19.12.2007
(73) Patentinhaber: PV Silicon Forschungs und Produktions GmbH, 99099 Erfurt (DE)
(72) Erfinder: ABROSIMOV, Nikolai, 12555 Berlin (DE); LÜDGE, Anke, 15732 Schulzendorf (DE); MUIZNIEKS, Andris, LV-1058 Riga (LV); RIEMANN, Helge, 15732 Schulzendorf (DE)
(74) Vertreter: Hoffmann, Heinz-Dietrich
(86) Internationale Anmeldenummer: PCT/EP2006/003196
(87) Internationale Veröffentlichungsnummer: WO 2006/105982

(56) Entgegenhaltungen:
- DE-A1- 2 538 854
- DE-A1- 3 608 889
- DE-A1- 10 220 964
- US-A- 4 797 525
- PATENT ABSTRACTS OF JAPAN Bd. 011, Nr. 008 (C-396), 9. Januar 1987 (1987-01-09) & JP 61 186279 A (SUMITOMO ELECTRIC IND LTD), 19. August 1986 (1986-08-19)

## Beschreibung

Die Erfindung betrifft ein Verfahren zur Herstellung einer einkristallinen Si-Scheibe mit annähernd polygonalem Querschnitt und der Materialqualität zonengezogener Si-Kristalle und eine derartige einkristalline Si-Scheibe.

Es ist bekannt, dass nach dem Czochralski (CZ)-Verfahren aus dem Tiegel quadratische Kristalle in <100> Richtung gezogen wurden, wenn der radiale Temperaturgradient in der Schmelze klein genug war. Ein solcher Vorgang ist aber instabil, d.h. der Querschnitt des Kristalls ändert sich sehr leicht bei kleinen Variationen der Temperatur. Auch sind wegen der kleinen Temperaturgradienten nur kleine Ziehgeschwindigkeiten möglich. Weiterhin ist bekannt, dass die Verunreinigungspegel des CZ-Si gegenüber Float Zone (FZ)-Silicium höher sind.

Heutzutage werden z. B. für Solarzellen quadratische bzw. quasiquadratische einkristalline Wafer hergestellt, indem man mit bis zu 36% Materialverlust vom runden Kristallquerschnitt entsprechende Segmente abtrennt.

Die Rotationsachse eines wachsenden FZ-Kristalls, der verfahrensbedingt auf seinem "Dünnhals" steht, ist nicht die Hauptträgheitsachse, wenn seine Länge den Durchmesser übersteigt. Seine Rotationsbewegung ist somit aus physikalischen Gründen instabil. Insbesondere bei in der Praxis üblichen großen Kristallen (z. B. Durchmesser 150 mm, Länge 1,5 m) nehmen - ausgelöst durch stets vorhandene kleine Störungen (Erschütterungen, Unwuchten) - mit steigender Rotationsrate Ausschläge des Kristalls und der Schmelze zu, die zur Versetzungsbildung beitragen bzw. eine weitere Steigerung von Durchmesser bzw. Ziehlänge des Kristalls begrenzen.

Für die Herstellung von zonengezogenen einkristallinen Stäben mit rundem Querschnitt sind dem Stand der Technik nach verschiedene Lösungen bekannt.

So ist in DD 263 310 A1 ein Verfahren beschrieben, bei dem durch den gleichen Drehsinn von Kristallrotation und rotierendem Magnetfeld Einflüsse der erzwungenen Konvektion entfallen.

Ein Verfahren, bei dem die Drehrichtungen von Einkristall und Magnetfeld gegensinnig sind, ist in DE 100 51 885 A1 beschrieben. Hierbei wird in der Schmelze eine Volumenkraft in azimutaler Richtung bewirkt, wodurch eine spezielle Strömung in der Schmelze entsteht, die einen längeren Aufenthalt der Partikel in der Schmelze und somit eine gute Durchmischung und vollständige Aufschmelzung bewirkt. Dieser Prozess kann durch die Anwendung eines zweiten Magnetfeldes mit anderer Frequenz und zeitlich veränderlicher Amplitude verbessert werden.

Bei dem Verfahren, das in DE 36 13 949 A1 zur Herstellung runder einkristalliner Halbleiterstäbe beschrieben ist, wird zusätzlich zum von der Hf-Heizspule erzeugten hochfrequenten Wechselfeld ein parallel zur Ziehachse verlaufendes magnetisches Gleichfeld mittels einer zylinderförmigen Spule, die die Schmelzzone und die Hf-Heizspule umgibt, angelegt, wodurch eine Wirbelstromdämpfung der Konvektion der Schmelze erreicht werden soll.

Auch in der in US-Patent 5,556,461 beschriebenen Lösung zur Herstellung von runden einkristallinen Si-Stäben mittels FZ-Methode, wobei die polykristallinen Si-Stäbe durchschnittliche Korngrößen von 10 bis 1000 µm aufweisen, werden zusätzlich Mittel zur Erzeugung eines statischen Magnetfeldes angeordnet, wodurch die Wirbel in der Schmelze unterdrückt werden sollen. Bei der Züchtung werden Ausgangskristallstab und wachsender Einkristallstab gedreht.

Zur Dotierung von zonengezogenem Halbleitermaterial mit rundem Querschnitt wird der Schmelze ein Dotierstoff hinzugefügt, wie beispielsweise in DE 102 16 609 A1 beschrieben. Die den Dotierstoff enthaltene Schmelze wird mindestens einem rotierenden Magnetfeld ausgesetzt. Beim Erstarren der Schmelze werden der entstehende Einkristall mit einer Geschwindigkeit von mindestens 1 U/min und das Magnetfeld gegensinnig gedreht.

Für die Industrie ist es von Bedeutung, materialsparend Si-Wafer herzustellen. Der bisherige Materialverlust durch Schneiden von runden Si-Scheiben in Wafer bestimmten Querschnitts ist nicht mehr vertretbar.

In DE 36 08 889 A1 ist ein Verfahren zur Herstellung einkristalliner Halbleiterstäbe mit polygonalem Querschnitt mittels Czochralski-Züchtung beschrieben, bei dem der Schmelzoberfläche ein definiertes Temperaturfeld, das der Symmetrie des wachsenden Kristalls entspricht, aufgeprägt wird. Hierfür ist ein Kühlsystem vorgesehen, das gleichsinnig mit dem und gleich schnell wie der Impfkristall rotiert. Infolge der beeinflussten Temperaturverteilung wird ein von der üblichen Zylinderform abweichendes Kristallwachstum realisiert.

In DE 102 20 964 A1 wird eine Lösung zur Herstellung von polykristallinen Kristallstäben mit definiertem Querschnitt mittels tiegelfreier kontinuierlicher Kristallisation beschrieben, wobei über die veränderlich einstellbaren Abstände zwischen Induktionsspule und Tiegel sowie Induktionsspule und Kristallisationsfront mit nur einem gemeinsamen Heizmittel, nämlich der Induktionsspule, das Kristallmaterial im Tiegel geschmolzen und die Kristallisationsfront auf dem wachsenden polykristallinen Kristallstab eingestellt wird. Nicht aufgeschmolzene Si-Partikel sollen so auch nicht zur Phasengrenze gelangen. Ein dicht über dem wachsenden Kristallstab angeordneter Rahmen, der die Schmelze berührt, gibt die Form des wachsenden Kristallstabes, seinen Querschnitt, vor.

Aufgabe der Erfindung ist es nun, ein Verfahren zur Herstellung einer einkristallinen Si-Scheibe mit annähernd polygonalem Querschnitt und der Materialeigenschaft zonengezogener Si-Kristalle anzugeben, das wesentliche Materialeinsparungen garantiert, Kristalle mit großem Durchmesser und großer Ziehlänge ermöglicht und weniger aufwändig ist als bisher bekannte Verfahren.

Erfindungsgemäß wird die Aufgabe durch ein Verfahren zur Herstellung einer einkristallinen Si-Scheibe mit annähernd polygonalem Querschnitt gelöst, bei dem in einer Startphase aus einem hängenden Schmelztropfen mit bekannten Mitteln zumindest ein Dünnhals vertikal abwärts gezogen wird, bevor die Kristallrotation auf eine Drehzahl zwischen 0 und < 1 U/min reduziert und anschließend in einer Züchtungsphase ein Si-Einkristall mit annähernd polygonalem Querschnitt vertikal abwärts gezogen wird, wobei ein Induktor, aufweisend Mittel zur vieleckigen Stromverteilung, zur Erzeugung eines Temperaturprofils verwendet wird, dessen Form an der Wachstumsphasengrenze mit der Form des Querschnitts des zu ziehenden Kristallstabes korrespondiert, dann das stationäre Wachstum des Kristallstabes bei Erreichung der gewünschten Ziehlänge beendet und der Kristallstab zu Scheiben mit polygonalem Querschnitt geschnitten wird.

Bisher bestand in der Fachwelt allgemeiner Konsens, dass Kristalle mit Durchmessern über ca. 40 mm nach dem FZ-Verfahren (Nadelöhrverfahren) nur unter Rotation mit Umdrehungsgeschwindigkeiten von mindestens 1 U/min gezogen werden können und folglich rund sein müssen, wie auch die Vielzahl der erwähnten dem Stand der Technik nach bekannten Lösungen widerspiegelt. Insbesondere bewirke die lokale Überhitzung unter dem Induktorspalt eine lokale Absenkung der Wachstumsphasengrenze, wodurch die Schmelze auslaufen kann oder Versetzungen entstehen können.

Das erfindungsgemäße Verfahren bietet nunmehr die Möglichkeit, in der Züchtungsphase auch ohne Rotation zu arbeiten, wie in einer Ausführungsform vorgesehen ist. Damit entfallen rotationsbedingte Störungen wie periodische Temperaturschwankungen an der Phasengrenze und mechanische Schwingungen und Präzessionsbewegungen des wachsenden Kristalls und der Schmelzzone, die das Kristallwachstum empfindlich stören können. Wegen der verbesserten mechanischen Stabilität wird außerdem die Züchtung von Kristallen mit großem Durchmesser (z. B. 200 mm) sicherer.

Eine verbesserte Materialausbeute bei der Herstellung von polygonalen Wafern wird durch die einstellbaren annähernd polygonalen Querschnitte erreicht. Der verwendete Induktor kann z. B. Schlitze zur definierten Stromverteilung in der Schmelzzone aufweisen, sodass die Form der Kristallisationsphasengrenze derart beeinflusst wird, dass sich der polygonale Querschnitt des Kristallstabes annähernd einstellt. Um einen möglichst symmetrischen polygonalen Querschnitt des wachsenden Kristallstabes zu erzielen, sind dem Fachmann bekannte Mittel vorzusehen, die die Wirkung des Hauptschlitzes den Wirkungen der Nebenschlitze angleichen.

Eine weitere Ausführungsform sieht vor, dass die Leistung des Induktors vor dem Reduzieren der Umdrehungszahl vorübergehend um max. 10 % reduziert wird. Damit wird erreicht, dass das Volumen der Schmelzzone verkleinert wird, um so einem Auslaufen der Schmelze in der Übergangsphse von rundem und zu polygonalem Querschnitt vorzubeugen.

In der oben erwähnten Ausführungsform der Erfindung wird die Kristallrotation nach Erzeugung eines dem Dünnhals folgenden konusförmigen Abschnittes bei Erreichung eines für die Flächenmaße des zu ziehenden Kristalls notwendigen Durchmessers angehalten. Diese Variante entspricht in der Startphase zur Herstellung des Dünnhalses und des sich dann ausbildenden konusförmigen Abschnittes dem Stand der Technik nach üblichen Verfahren, dem sich danach die eigentliche Züchtungsphase hier erfindungsgemäß ohne Rotation anschließt.

In einer weiteren Ausführung wird erfindungsgemäß die Kristallrotation in einer solchen azimutalen kristallographischen Ausrichtung des zu ziehenden Kristallstabes relativ zu den Schlitzen des Induktors angehalten, bei der die Kristallsymmetrie der Induktorsymmetrie angepasst ist. Damit wird ein annähernd gleich bleibender Querschnitt gewährleistet.

Soll nun ein einkristalliner Si-Stab mit annähernd quadratischem Querschnitt hergestellt werden, so wird ein Induktor mit einem Haupt- und drei Nebenschlitzen verwendet, wobei die Spaltmaße dem gewünschten Querschnitt angepasst sind und die Schlitze den Diagonalen des entstehenden quadratischen Querschnitts folgen. Besonders vorteilhaft hat sich erwiesen, den Si-Stab in der Züchtungsphase in Intervallen um jeweils genau 90° periodisch zu drehen, wobei die Verweilzeit des wachsenden einkristallinen Si-Stabes in einer definierten Position wesentlich länger ist als die Zeit für dessen 90°-Drehung.

Zur Züchtung eines einkristallinen Si-Stabes mit annähernd rundem Querschnitt in der Form eines stark verrundeten Polygons wird der nicht rotierende Si-Stab in einer weiteren Ausführungsform zusätzlich einem rotierenden Magnetfeld mit einer Frequenz unter 1000 Hz ausgesetzt. Dieses zusätzliche AC-Magnetfeld erzeugt dabei in der Schmelze eine azimutale Rotationsströmung, die die Wärme transportiert und damit die Rotationssymmetrie der Temperaturverteilung erhöht, sodass ein nahezu runder Querschnitt erreicht wird. Gleichzeitig wird auch die Dotierungsverteilung in der Schmelze homogenisiert und eine gleichmäßigere Diffusionsrandschicht an der Wachstumsphasengrenze auch für den Fall eines nicht rotierenden Kristallstabes erzeugt. Das rotierende Magnetfeld kann so als Äquivalent für die dem Stand der Technik nach bekannte Kristallrotation angesehen werden, ist aber zur Lösung der gestellten Aufgabe nicht zwingend notwendig.

Ebenfalls optional ist vorgesehen, zusätzlich zum angelegten Magntefeld den wachsenden Kristall sehr langsam, d.h. mit einer Drehzahl < 1 U/min, zu rotieren.

Die erfindungsgemäße Lösung beinhaltet auch eine einkristalline Si-Scheibe mit annähernd polygonalem Querschnitt und den Materialeigenschaften zonengezogenen Siliciums, gekennzeichnet durch einen annähernd polygonalen Striationverlauf mit n-zähliger Geometrie auf ihrer Oberfläche, herstellbar durch ein Verfahren mit den folgenden Verfahrensschritten: In einer Startphase wird aus einem hängenden Schmelztropfen mit bekannten Mitteln zumindest ein Dünnhals vertikal abwärts gezogen, bevor die Kristallrotation auf eine Drehzahl zwischen 0 und < 1 U/min reduziert und anschließend in einer Züchtungsphase ein Si-Einkristall mit annähernd polygonalem Querschnitt vertikal abwärts gezogen wird, wobei ein Induktor, aufweisend Mittel zur vieleckigen Stromverteilung, zur Erzeugung eines Temperaturprofils verwendet wird, dessen Form an der Wachstumsphasengrenze mit der Form des Querschnitts des zu ziehenden Kristallstabes korrespondiert, dann das stationäre Wachstum des Kristallstabes bei Erreichung der gewünschten Ziehlänge beendet und der Kristallstab zu Scheiben mit polygonalem Querschnitt geschnitten wird.

Es hat sich gezeigt, dass Si-Kristalle mit annähernd polygonalem Querschnitt, die nach dem erfindungsgemäßen Verfahren hergestellt wurden, einen unrunden Striationverlauf mit einer Geometrie aufweisen, die der des Polygons ihres Querschnitts entspricht.

Ein analoges Ergebnis konnte für annähernd quadratische einkristalline Si-Scheiben erreicht werden, diese weisen einen annähernd quadratischen Striationverlauf mit vierzähliger Geometrie auf und sind herstellbar durch ein Verfahren mit folgenden Verfahrensschritten: in einer Startphase wird aus einem hängenden Schmelztropfen mit bekannten Mitteln zumindest ein Dünnhals vertikal abwärts gezogen, bevor die Kristallrotation in einer solchen azimutalen kristallographischen Ausrichtung des wachsenden Kristallstabes relativ zu den Schlitzen des Induktors angehalten wird, bei der die Kristallsymmetrie der Induktorsymmetrie angepasst ist, wobei ein Induktor mit einem Haupt- und drei Nebenschlitzen verwendet wird, dessen Spaltmaße dem gewünschten Querschnitt angepasst und die Schlitze in Richtung der Diagonalen des zu züchtenden Querschnitts ausgerichtet werden, anschließend in einer Züchtungsphase ein Si-Einkristall mit annähernd quadratischem Querschnitt vertikal abwärts gezogen wird, dann das stationäre Wachstum des Kristallstabes bei Erreichung der gewünschten Ziehlänge beendet und der Kristallstab zu Scheiben mit quadratischem Querschnitt geschnitten wird.

Die Erfindung wird in folgendem Ausführungsbeipiel zur Herstellung von einkristallinen Si-Scheiben mit annähernd quadratischem Querschnitt anhand von Figuren näher beschrieben.

So zeigen:
- Fig. 1:: eine Gesamtansicht eines mit dem erfindungsgemäßen Verfahren gezüchteten einkristallinen Si-Stabes mit annähernd quadratischem Querschnitt;
- Fig. 2:: das Grauwertbild des Striationverlaufs in einer Si-Scheibe aus einem Stab gem. Fig. 1;
- Fig. 3:: die Draufsicht auf eine Si-Scheibe aus einem Stab gem. Fig. 1;
- Fig. 4:: einen Induktor mit sechs Schlitzen.

Der zur Züchtung eines einkristallinen Si-Stabes mit annähernd quadratischem Querschnitt verwendete Induktor, der dem Stand der Technik nach bekannt ist, weist vier Schlitze auf, einen Haupt- und drei Nebenschlitze. Da der Hauptschlitz (Stromzuführung) bis zum Induktorrand gehen muss, wird sein Magnetfeld durch eine Metallplatte, die ihn im peripheren Bereich überlappt, abgeschirmt bzw. abgeschwächt.

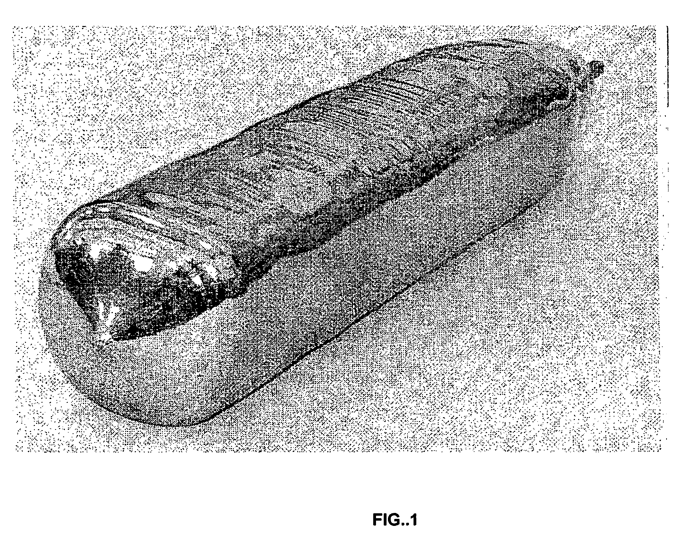

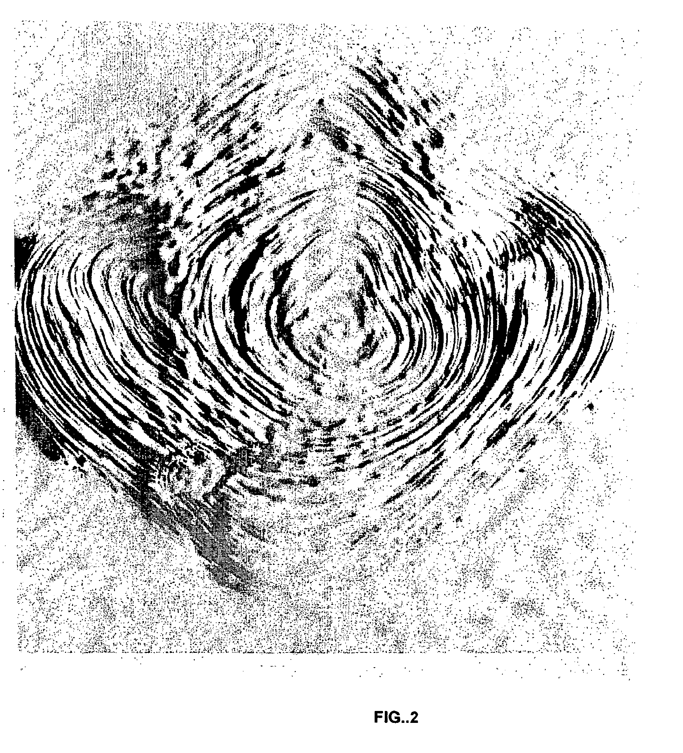

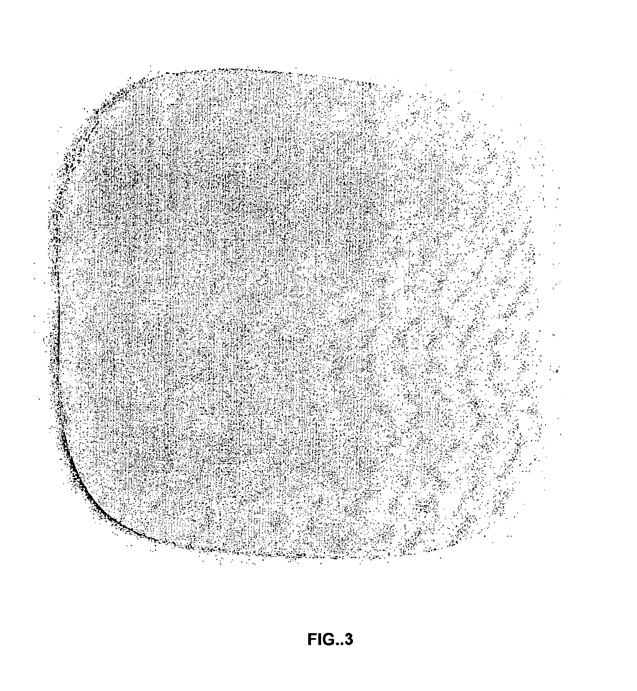

Die Kristallzüchtung des Kristallstabes mit annähernd quadratischem Querschnitt startet in bekannter Weise wie ein üblicher FZ-Prozess. Es wurde zunächst ein Dünnhals und dann ein versetzungsfreier kegliger Kristallkonus unter Rotation bis zu einem Durchmesser gezogen, der den Bereich der Nebenschlitze überdeckt. Sodann wurde die HF-Leistung um ca. 5 % reduziert, was zur Verringerung des Schmelzvolumens und einem Abflachen des Randwinkels der Oberfläche der Schmelze an der unteren Phasengrenze führte. In dieser Situation wurde die Kristallrotation angehalten und zwar in einer für die hier vorliegende <100>-Orientierung günstigen azimutalen Ausrichtung der vier Wachstumsnähte des Kristalls in Flucht mit den Induktorschlitzen. An diesen Positionen bildeten sich vertikale Einkerbungen der Phasengrenze, verbunden mit dem Herauswachsen von vier Ausstülpungen der Kristalloberfläche. Im weiteren Verlauf wurde allmählich wieder die HF- Leistung auf den ursprünglichen Wert erhöht, und es stabilisierte sich ein quasi-quadratischer Querschnitt, der stationär unter Erhalt der versetzungsfreien Struktur weitergeführt werden konnte. Nach ca. 30 cm stationären Wachstums wurde der Versuch störungsfrei durch Trennen der Schmelzzone beendet. Fig. 1 zeigt eine Gesamtansicht des einkristallinen Si-Stabes mit quadratischem Querschnitt und einer Ziehlänge von ca. 30 cm. In Fig. 2 ist das Grauwertbild des annähernd quadratische Striationverlauf in einer Kristallscheibe eines Si-Stabes gemäß Fig. 1 dargestellt. Die Störung ist unabhängig von der erfindungsgemäßen Lösung und zurückzuführen auf Spannungen, die während des Schneidens hervorgerufen wurden. Fig. 3 zeigt eine Scheibe mit annähernd quadratischem Querschnitt.

Der Querschnitt des Kristalls wird bei diesem Beispiel im wesentlichen durch die Dimension und Anordnung der Nebenschlitze des Induktors und durch das Anhalten der Kristallrotation bewirkt. Dabei musste das Problem gelöst werden, dass die Schmelze beim noch runden Querschnitt des kegelförmigen Kristallkonus unmittelbar nach dem Stopp der Kristallrotation auslaufen kann. Dem wurde begegnet, indem das Magnetfeld des Hauptschlitzes konstruktiv geschwächt wurde und indem vor dem Anhalten das Volumen der Schmelzzone durch Leistungsabsenkung verkleinert wurde. Die annähernd quadratische Symmetrie des Kristallquerschnitts konnte in weiteren Versuchen durch periodisches Drehen des Kristalls um jeweils genau 90° und/oder Feinanpassung der Spaltmaße des Induktors an den gewünschten Querschnitt verbessert werden.

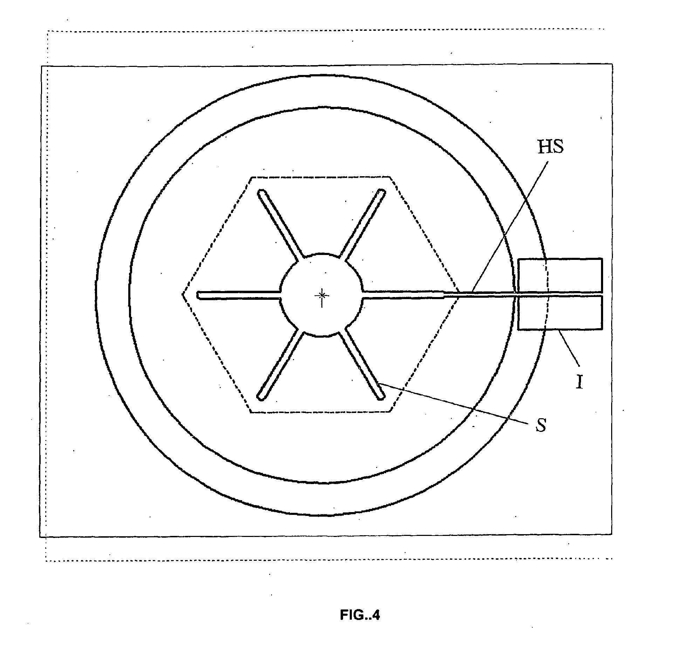

Fig. 4 zeigt in der Draufsicht einen Induktor mit sechs Schlitzen S, der für die Herstellung einkristalliner Si-Scheiben mit sechseckigem Querschnitt verwendet werden kann. Erkennbar ist ebenfalls, dass der in Richtung der Stromzuführung I gerichtete Hauptschlitz HS dünner ausgebildet ist, um den Einfluss des Hauptschlitzes zu verringern. Die gestrichelte Linie stellt die Kontur des wachsenden Kristalls mit annähernd sechseckigem Querschnitt dar.

Die erfindungsgemäße Lösung ermöglicht durch die Induktorausformung, die azimutale Ausrichtung des Kristalls und das Anhalten bzw. Reduzieren der Rotation in der Züchtungsphase die Herstellung von einkristallinen Si-Stäben mit anwendungsbezogenen Kristallquerschnitten, die eine wesentliche Materialeinsparung gegenüber runden Kristallen erlauben.

## Patentansprüche

1. Verfahren zur Herstellung einer einkristallinen Si-Scheibe mit annähernd polygonalem Querschnitt und der Materialqualität zonengezogener Si-Kristalle, bei dem
in einer Startphase aus einem hängenden Schmelztropfen mit bekannten Mitteln zumindest ein Dünnhals vertikal abwärts gezogen wird,
bevor die Kristallrotation auf eine Drehzahl zwischen 0 und < 1 U/min reduziert und
anschließend in einer Züchtungsphase ein Si-Einkristall mit annähernd polygonalem Querschnitt vertikal abwärts gezogen wird,
wobei ein Induktor, aufweisend Mittel zur vieleckigen Stromverteilung, zur Erzeugung eines Temperaturprofils verwendet wird, dessen Form an der Wachstumsphasengrenze mit der Form des Querschnitts des zu ziehenden Kristallstabes korrespondiert,
dann das stationäre Wachstum des Kristallstabes bei Erreichung der gewünschten Ziehlänge beendet und der Kristallstab zu Scheiben mit polygonalem Querschnitt geschnitten wird.

2. Verfahren nach Anspruch 1, bei dem
die Leistung des Induktors vor dem Reduzieren der Umdrehungszahl vorübergehend um max. 10 % reduziert wird.

3. Verfahren nach Anspruch 1, bei dem
die Rotation bei Erreichung eines für die Flächenmaße des zu ziehenden Kristalls notwendigen Durchmessers angehalten, d.h. auf 0 U/min reduziert, wird.

4. Verfahren nach Anspruch 1 und 3, bei dem
die Kristallrotation erst nach Bildung eines dem Dünnhals folgenden konusförmigen Abschnittes nach Erreichung eines für die Flächenmaße des zu ziehenden Kristalls notwendigen Durchmessers angehalten wird.

5. Verfahren nach Anspruch 1, bei dem
die Kristallrotation in einer solchen azimutalen kristallographischen Ausrichtung des wachsenden Kristallstabes relativ zu den Schlitzen des Induktors angehalten wird, bei der die Kristallsymmetrie der Induktorsymmetrie angepasst ist.

6. Verfahren nach Anspruch 1 und 5, bei dem
zur Herstellung eines einkristallinen Si-Stabes mit annähernd quadratischem Querschnitt ein Induktor mit einem Haupt- und drei Nebenschlitzen verwendet wird, wobei die Spaltmaße dem gewünschten Querschnitt angepasst sind, und die Schlitze des Induktors nach seinem Anhalten den Diagonalen des entstehenden quadratischen Querschnitts folgen.

7. Verfahren nach Anspruch 6, bei dem
im Falle eines zu ziehenden <100>-Kristalls die vier Wachstumsnähte in Flucht mit den vier Induktorschlitzen angeordnet werden.

8. Verfahren nach Anspruch 1 und 6, bei dem
in der Züchtungsphase des einkristallinen Si-Stabes mit annähernd quadratischem Querschnitt der Si-Stab in Intervallen um jeweils genau 90° periodisch gedreht wird.

9. Verfahren nach Anspruch 8, bei dem
die Verweilzeit des einkristallinen Si-Stabes mit annähernd quadratischem Querschnitt in einer definierten azimutalen Position wesentlich länger ist als die Zeit der Drehung des Si-Stabes.

10. Verfahren nach Anspruch 1, bei dem
zur Herstellung eines zonengezogenen einkristallinen Si-Stabes mit verrundetem polygonalem Querschnitt der Si-Stab zusätzlich einem rotierenden Magnetfeld mit einer Frequenz unter 1000 Hz ausgesetzt wird.

11. Verfahren nach Anspruch 10, bei dem
der wachsende Kristall sehr langsam mit einer Drehzahl < 1 U/min rotiert.

## Claims

1. A method for producing a monocrystalline Si wafer having an approximately polygonal cross-section and the material quality of zone-pulled Si crystals, wherein
in an initial phase at least one thin neck is pulled vertically downwards from a suspended melt drop by known means
before crystal rotation is reduced to a rotational speed between 0 and <1 rpm; and
subsequently in a growing phase a Si monocrystal having an approximately polygonal cross-section is pulled vertically downwards,
an inductor, which comprises means for polygonal current distribution, being used to generate a temperature profile, the shape of which at the growth phase limit corresponds to the shape of the cross-section of the crystal ingot to be pulled;
then the stationary growth of the crystal ingot is terminated when the desired pulling length is reached, and the crystal ingot is cut into wafers having a polygonal cross-section.

2. A method according to claim 1 wherein
the output of the inductor is temporarily reduced by a maximum of 10 % prior to the reduction of the rotational speed.

3. A method according to claim 1 wherein
the rotation is stopped, i.e. reduced to 0 rpm, when a diameter required for the desired surface dimensions of the crystal to be pulled is reached.

4. A method according to claim 1 and claim 3 wherein
the crystal rotation is only stopped after formation of a cone-shaped section following the thin neck after a diameter required for the desired surface dimensions of the crystal to be pulled is reached.

5. A method according to claim 1 wherein
the crystal rotation is stopped in an azimuthal crystallographic orientation of the growing crystal ingot relative to the slits of the inductor, in which the crystal symmetry matches the inductor symmetry.

6. A method according to claim 1 and claim 5 wherein
for the production of a monocrystalline Si ingot having an approximately square cross-section an inductor with one main slit and three secondary slits is used, the slit widths being adapted to the desired cross-section, and the slits of the inductor after stopping it following the diagonals of the forming square cross-section.

7. A method according to claim 6 wherein
in case the crystal to be pulled is a <100> crystal, the four growth seams are arranged in alignment with the four inductor slits.

8. A method according to claim 1 and claim 6 wherein
in the growing phase of the monocrystalline Si ingot having an approximately square cross-section the Si ingot is periodically rotated by exactly 90° each in intervals.

9. A method according to claim 8 wherein
the residence time of the monocrystalline Si ingot having an approximately square cross-section in a defined azimuthal position is significantly longer than the time of rotation of the Si ingot.

10. A method according to claim 1 wherein
for the production of a zone-pulled monocrystalline Si ingot having a rounded polygonal cross-section the Si ingot is additionally exposed to a rotating magnetic field having a frequency below 1000 Hz.

11. A method according to claim 10 wherein
the growing crystal rotates very slowly with a rotational speed of < 1 rpm.

## Revendications

1. Procédé pour produire une tranche de silicium monocristalline à section pratiquement polygonale et la qualité de matériau de cristaux de silicium obtenus par tirage avec zone flottante dans lequel
dans une phase initiale, au moins une extrémité fine est tirée verticalement vers le bas à l'aide de moyens connus à partir d'une goutte fondue suspendue, avant que la rotation du cristal ne soit réduite à une vitesse comprise entre 0 et moins de 1 tour/mn et
ensuite, dans une phase de croissance, un monocristal de silicium à section pratiquement polygonale est tiré verticalement vers le bas,
un inducteur présentant des moyens pour former une répartition de courant étant utilisé pour générer un profil de température dont la forme à la limite de la phase de croissance correspond à la forme de la section du lingot de cristal à tirer,
puis, la croissance stationnaire du lingot de cristal est arrêtée lorsque la longueur de tirage désirée est atteinte et le lingot de cristal est découpé en tranches à section polygonale.

2. Procédé selon la revendication 1, dans lequel
la puissance de l'inducteur est réduite provisoirement d'un maximum de 10 % avant la réduction de la vitesse de rotation.

3. Procédé selon la revendication 1, dans lequel
à l'atteinte d'un diamètre nécessaire pour la dimension de surface du cristal à tirer, la rotation est arrêtée, c'est à dire réduite à 0 tour /mn.

4. Procédé selon les revendications 1 et 3, dans lequel
la rotation du cristal n'est arrêtée qu'après la formation d'une section conique suivant l'extrémité fine, après atteinte d'un diamètre nécessaire pour les dimensions de surface du cristal à tirer.

5. Procédé selon la revendication 1, dans lequel,
la rotation du cristal est arrêtée dans une orientation cristallographique azimutale du lingot de cristal croissant par rapport aux encoches de l'inducteur dans laquelle la symétrie du cristal est adaptée à la symétrie de l'inducteur.

6. Procédé selon les revendications 1 et 5, dans lequel
pour la fabrication d'un lingot de silicium monocristallin à section pratiquement quadratique, un inducteur avec une encoche principale et trois encoches auxiliaires est utilisé, les dimensions des encoches étant adaptées à la section souhaitée et les encoches de l'inducteur suivant après son arrêt les diagonales de la section quadratique naissante.

7. Procédé selon la revendication 6, dans lequel
dans le cas d'un cristal <100> à tirer, on dispose les quatre joints de croissance en alignement sur les quatre encoches de l'inducteur.

8. Procédé selon les revendications 1 et 6, dans lequel
dans la phase de croissance du lingot de silicium monocristallin à section pratiquement quadratique, on fait tourner périodiquement à intervalles le lingot de silicium de précisément 90°.

9. Procédé selon la revendication 8, dans lequel
dans une position azimutale définie, le temps de séjour du lingot de silicium monocristallin à section pratiquement quadratique est supérieur au temps de rotation du lingot de silicium.

10. Procédé selon la revendication 1, dans lequel
pour la production d'un lingot de silicium monocristallin obtenu par tirage avec zone flottante, à section polygonale arrondie, le lingot de silicium monocristallin est exposé en outre à un champ magnétique en rotation d'une fréquence inférieure à 1000 Hz.

11. Procédé selon la revendication 10, dans lequel
le cristal croissant tourne très lentement à une vitesse < 1 tour/mn.
